# EUROPEAN PATENT SPECIFICATION

(11) **EP 1 228 570 B1**
(45) Date of publication and mention of the grant of the patent: **01.03.2006**
(21) Application number: 00991715.4
(22) Date of filing: 02.11.2000
(51) Int. Cl.: H03M 7/30

(54) **VARIABLE LENGTH ENCODING OF COMPRESSED DATA**
KODIERSYSTEM VON KOMPRIMIERTEN DATEN MIT VARIABLER WORTLÄNGE
CODAGE A LONGUEUR VARIABLE DE DONNEES COMPRESSEES

(30) Priority: 09.11.1999 US 164330; 28.03.2000 US 536638
(43) Date of publication of application: 07.08.2002
(73) Proprietor: Nokia Corporation, 02150 Espoo (FI)
(72) Inventor: LE, Khiem, Coppell, TX 75019 (US); LIU, Zhigang, Irving, TX 75063 (US); LEON, David, Irving, TX 75038 (US)
(74) Representative: Read, Matthew Charles
(86) International application number: PCT/US2000/041773
(87) International publication number: WO 2001/035534

(56) References cited:
- US-A- 5 293 379
- CASNER S ET AL: "Compressing IP/UDP/RTP Headers for Low-Speed Serial Links" IETF INTERNET DRAFT, 27 July 1998 (1998-07-27), XP002125101
- DEGERMARK M ET AL: "LOW-LOSS TCP/IP HEADER COMPRESSION FOR WIRELESS NETWORKS" WIRELESS NETWORKS,US,ACM, vol. 3, no. 5, 1 October 1997 (1997-10-01), pages 375-387, XP000728935 ISSN: 1022-0038
- HANDLEY M: "GERM: GENERIC RTP MULTIPLEXING" INTERNET ENGINEERING TASK FORCE,XX,XX, 11 November 1998 (1998-11-11), pages 1-7, XP002139359

## Description

Reference is made to U.S. Patent Application Serial No. 09/522,497, filed on March 9, 2000, entitled "An Efficient Handoff Procedure for Header Compression".

Reference is also made to U.S. Patent Application Serial No. 09/536,639, filed on March 28,2000, entitled "Method and System for Transmitting and Receiving Packets".

The invention relates to compression.

There are many areas where it is critical to be able to compress a sequence of values, in an manner that is efficient and robust to errors. An example is IP/UDP/RTP header compression to carry real-time IP-based multi-media traffic over cellular networks. Due to the large size of the IP/UDP/RTP header and the bandwidth limitations of cellular systems, compression efficiency is a must. Error robustness is also required due to the error-prone characteristics of the cellular link.

The RTP header compression described in Internet Engineering Task Force (IETF) RFC 2508, February 1999, achieves high compression efficiency on a lossless compressor-decompressor link. It can compress most of the headers to as low as two bytes. However, this scheme is not robust to errors. The problems encountered are error propagation and increased compressed header sizes. Error propagation refers here to the fact that if a compressed header is hit by an error, not only is this compressed header not decodable but the following compressed headers will likely not be decodable even though they are error free. Increased compressed header size refers here to the fact that because of the error recovery procedure, compressed headers on a lossy link are larger than the optimal 2 bytes achieved on a lossless link. Limitations of RFC 2508 are hereinafter discussed.

Header compression schemes take advantage of the fact that certain information fields carried in the headers either 1.) do not change (called here 'Type 1' header fields) or 2.) change in a fairly predictable way (called here 'Type 2' header fields). Other fields, referred to as 'Type 3' header fields, vary in such a way that they cannot be truly predicted.

Examples of Type 1 header fields are the IP address, UDP port number, RTP SSRC (synchronization source), etc. These fields need only be transmitted to the receiver/decompressor once during the course of a session (as part of the packet(s) transferred at session establishment, for example).

Examples of Type 2 header fields are the RTP time stamp, RTP sequence number, and IP ID fields. All have a tendency to increment by some constant amount from packet to packet. Thus, there is no need for these values to be transmitted within every header. It is only required that the decompressor be made aware of the constant increment (differential) value, called delta in RFC 2508. The decompressor utilizes these deltas to regenerate up-to-date Type 2 field values when reconstructing the original header. In other words, differential encoding is used to compress type 2 header fields.

The IP-ID field for most of IP stack implementations increments by a fixed amount for every packet sent by the source. Therefore as long as an RTP stream packets are not interleaved with other packets from the same source on the compressor-decompressor (CD)-channel, the IP-ID delta is constant and does not need to be transmitted.

An Example of a Type 3 header field is the RTP M-bit (Marker), which indicates the occurrence of some boundary in the media (e.g., end of a video frame). Because the media normally varies in unpredictable ways, this information cannot be truly predicted.

The above mentioned limitations of header compression schemes stem from the delta encoding used for type 2 fields. Because of differential encoding, if a single compressed header is lost, all the following compressed headers are not decodable because they are recursively predicted from a compressed header which is not decodable. This is what we called error propagation.

An algorithm used to recover from error propagation is known as the "twice" algorithm which can be used if the packet UDP checksum is transmitted in the compressed packet. Compressed packets on the CD-link carry a 4-bit sequence number which is incremented by one for each compressed packet sent by the compressor. The decompressor uses this sequence number to detect compressed packet loss on the link. If the sequence number increases by more than one, the decompressor hopes that all the compressed packet deltas have not changed since the last compressed packet delta and add one delta for each lost packet. The decompressor checks then that the assumption was valid by computing the decompressed packet UDP checksum and checking if it matches the transmitted UDP checksum.

The twice algorithm is too limiting. First, it requires transmission of the checksum (2 bytes) in every compressed packet and thus significantly reduces the compression efficiency. Second, for a typical audio stream, the twice algorithm works only if there has not been any TS or IP-ID jumps since the last decompressed packet.

When the decompressor is not able to decompress a packet, it sends an negative acknowledgment Nack to the compressor. Upon reception of Nack, the compressor has to send uncompressed header fields. The Nack mechanism thus incurs audio or video outages of a duration of at least one round-trip delay and decreased compression efficiency, since fields have to be sent uncompressed.

In order to limit error propagation, the compressor may use a refresh mechanism whereby it sends periodically uncompressed field values even though this is not requested by the decompressor. However such a mechanism further decreases compression efficiency.

Another limitation of RFC 2508 is the compressed header short sequence number. When the decompressor receives a header with a sequence number that is not consecutive from the previous one, packet loss is detected and a recovery scheme is employed to resynchronize the compressor and decompressor. Just using a short sequence number to detect packet loss is not robust to an error-prone link, such as wireless where 'long loss' may happen frequently. Long loss is defined as the loss of 'sequence cycle' or more packets in a row. When long loss occurs, the sequence number in the packet received by decompressor 'wraps around'. For example, assume the sequence number consists of k bits, hence the sequence cycle equals to 2^{k}. If 2^{k} packets are lost in a row, the decompressor fails to detect the packet losses since it still sees a consecutive sequence number in the incoming packets.

The invention is a robust and efficient encoding scheme which in one embodiment is referred to as VLE (variable length encoding). VLE and other embodiments of the invention may solve the error propagation and efficiency drop of the prior art.

The invention is based in part on the observation, that header type 2 fields received at the compression point shows an increasing trend. This implies that fields from consecutive headers tend to have the same MSBs (most significant bits) and differ only by their LSBs (least significant bits). Compression can thus be achieved by transmitting only the LSBs.

The invention allows the compressor to determine a minimum or reduced number of LSBs to be sent such as this number be sufficient to allow correct decompression whatever the loss of previous compressed packets on the CD-link.

The invention can be applied to any series of values. The more clustered (i.e. close to each other) the values, the higher the efficiency.

The invention is defined by the claims.
Fig. 1 conceptually illustrates compression of information.
Fig. 2 conceptually illustrates decompression of information.
Fig. 3 illustrates the transition of a compressor from transmitting headers having a higher number of bits to headers having a lower number of bits using acknowledgments in accordance with the present invention.
Fig. 4 illustrates the transition of a compressor from transmitting headers with a first order of compression to headers with a second order of compression in accordance with the present invention.
Figs. 5 and 6 illustrate examples of the selection of the minimum number of bits k in accordance with the invention.
Figs. 7A and 7B illustrate the use of a sliding window of values stored by the compressor in accordance with the invention.
Fig. 8 illustrates an example of VLE encoding format using two encoding fields for transmitting the compressed value in accordance with the present invention.

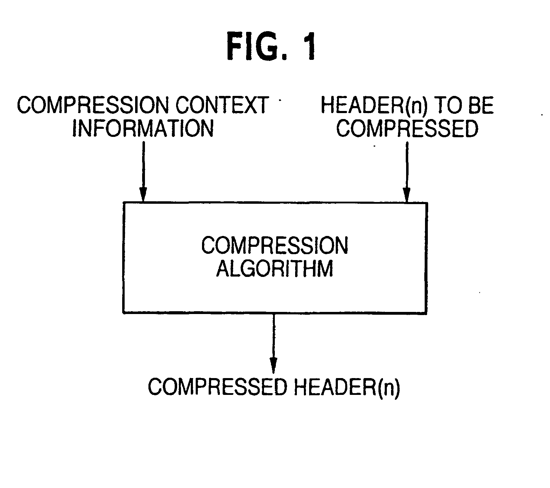

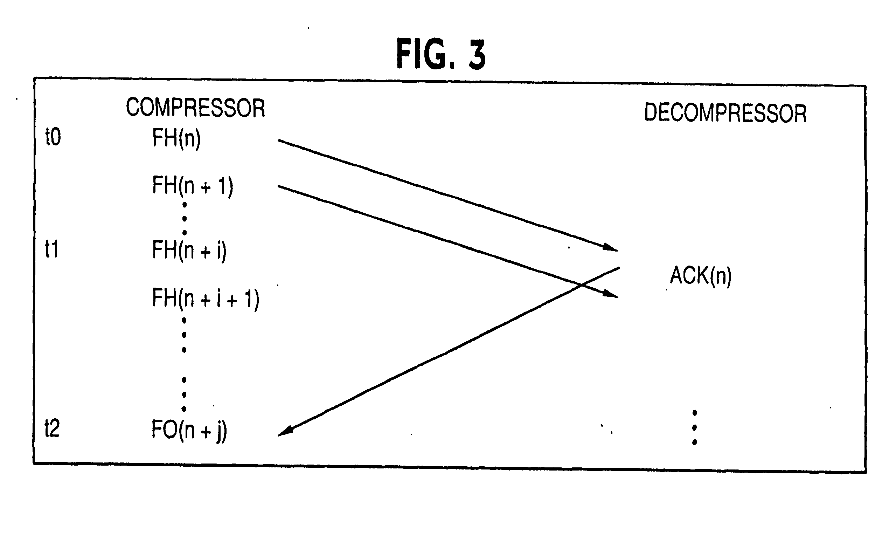

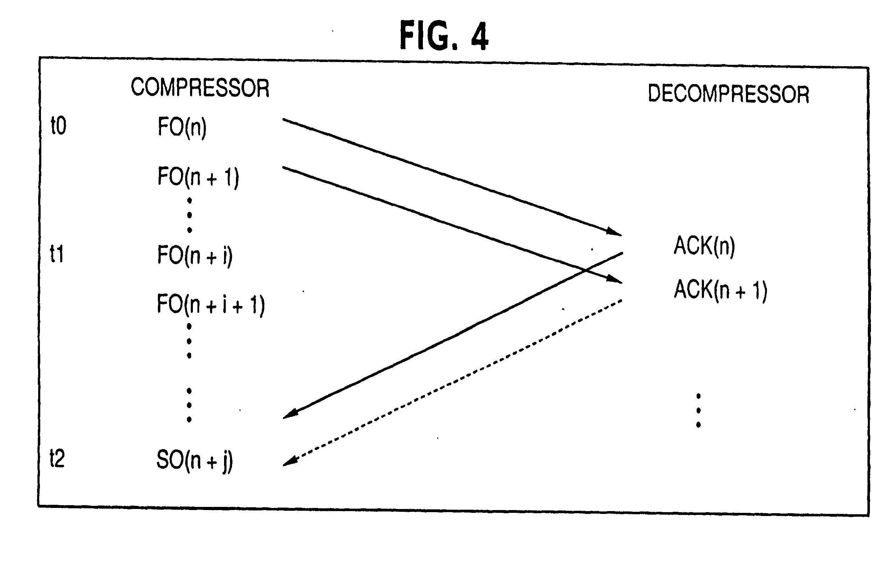

Fig. 1 illustrates conceptually compression information and examples thereof. Compression context information is a set, subset or representative of a subset of information which may be without limitation any type of information including a header used by a compressor as illustrated in Figs. 3 and 4 as an input to the compression algorithm to produce compressed information which may be without limitation a compressed header. The other input is from the source of the information to be compressed which is illustrated without limitation in the example as headers to be compressed.

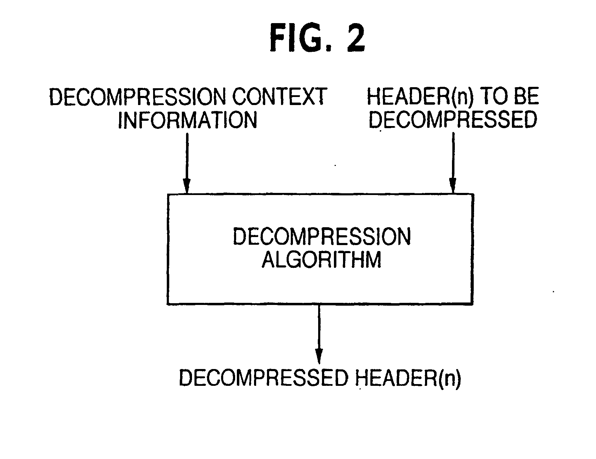

Fig. 2 illustrates conceptually decompression of information and examples thereof. Decompression context information is a set, subset or representation of a subset of information which may be without limitation of any type of information induding a header used by a decompression as illustrated in Figs. 3 and 4 as an input to the decompression algorithm to produce decompressed information which may be without limitation a decompressed header. The other input is from the information to be decompressed which is illustrated without limitation in the example as headers to be decompressed.

Both the compression and decompression context informations are dynamic, that is, they may be updated by the compressor and decompressor respectively. The frequency of updates depends on the header compression mechanism. Events that may result in an update of the compression context information at the compressor include the compression of an incoming header, or the receipt of feedback from the decompressor. Events that may result in an update of the decompression context information at the decompressor include the decompression of an incoming header.
The Compressor can be in one of 3 states:
- FH (Full Header) state
- FO (First Order) state
- SO (Second Order) state

The compressor operates in the FH state in the initialization phase. In the FH state, the compressor sends a full RTP header. This state is normally just a transient state which only happens at the beginning of an RTP session or in the middle of a session due to very exceptional events, e.g., the compressor fails or loses memory.

The compressor operates in the FO state in the update phase. In the FO state, the transmitter sends a FO header, i.e. a packet whose header carries the fields that have changed compared to the reference header, appropriately encoded, along with the sequence number. The decompressor is expected to acknowledge as illustrated in Figs. 3 and 4 a certain number of FOs, where the number depends on the pattern. For example, if the pattern is linear with constant parameters, only one acknowledgment is needed to transition to the extrapolation phase.

The compressor operates in the SO state in the extrapolation phase. In this state, the transmitter sends a SO packet, i.e. a packet whose header is essentially just a sequence number. The decompressor may or may not acknowledge a correctly received SO packet.

A type of mathematical function, which may be used with the invention but to which the invention is not limited, used in VLE is described as follows. Such a function, denoted as f(k,v_ref)=(v_1, v_2,....,v_2^{k}), maps to an integer value v_ref called reference value and a number of bits k to a k-tuple of integers which all have different k LSBs.

Although any such function could be appropriate, one preferred embodiment uses only functions which return consecutive values v_1, v_2,....,v_2^{k}, i.e. v_i = v_1 + i-1. In other words, the function has an interval of length 2^{k} values. The interval can be written as ]v_ref-C(k, v_ref), v_ref-C(k, v_ref)+2^{k}] where C is an integer value which is function of k and v_ref. Here again, although any such interval could be of interest, one preferred embodiment uses C(k, v_ref)=0 and C(k,v_ref)=2^{k-1}. In other words, the embodiment uses the intervals ]v_ref-2^{k-1}, v_ref+2^{k-1}] and ]v_ref, v_ref+2^{k}].

A VLE embodiment based on the ]v_ref-2^{k-1}, v_ref+2^{k-1}] interval is described as follows. The system is composed of a compressor, a decompressor and a CD-channel as illustrated in Fig. 3 and 4, i.e. the link between the compressor and the decompressor. The channel may be error-prone. The only assumptions made with this embodiment, which are not limiting, are that compressed values are not reordered by the channel and the compressed values which are given as inputs to the decompressor are not corrupted (or in other words corrupted headers are treated as lost headers). The channel may be a simplex link, i.e. carries only compressed values from the decompressor or duplex, i.e. the channel carries also feedback from the decompressor to the compressor as illustrated in Figs. 3 and 4. In the preferred embodiment a duplex channel is used.

The first phase is the acquisition by the decompressor of an initial value. This may be performed by the compressor sending uncompressed values at the start of the communication or any other suitable means. The decompressor may use a feedback channel to acknowledge the received value as illustrated in Figs. 3 and 4. The initialization is completed without limitation when the compressor has received one feedback acknowledgment and VLE encoding can then be used for compression. In VLE, values are compressed as a variable number of bits k. The operation of the decompressor in the VLE mode is first discussed.

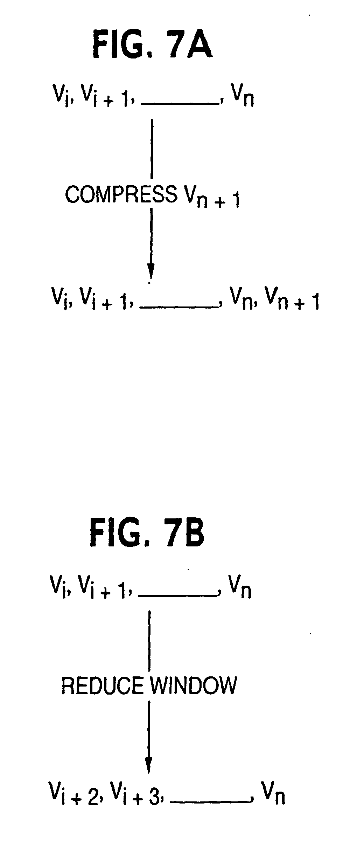

Figs. 7A and 7B illustrate a window update process. The window is comprised of previous values which are inputted to the compressor and may be compressed but are not required to be compressed. It is assumed that the window is vᵢ, vᵢ₊₁,_, vₙ at a contain point of time:
(1) When a new value Vₙ₊₁ is compressed, the window is enlarged in order to include this new value as illustrated in Fig. 7A.
(2) The window is then reduced, as illustrated in Fig. 7B, by removing older value(s) (in that example, vᵢ and vᵢ₊₁) when the compressor knows that these values cannot be used by the decompressor anymore which, in this example, could be when the reception of an acknowledgment for the value vᵢ₊₂ occurs.

### Decompression:

The reference value is the last value decompressed by the decompressor. The compressor may be signalled of decompression by the reception of an acknowledgment as illustrated in Figs. 3 and 4 or on the assumption that an actual value has been received in view of the transmission of a series of values over sufficient time duration that at least one value is statistically likely to be received and decompressed without use of any feedback from the decompressor. The decompressor decompresses an incoming compressed value by providing the only value in the interval ]v_ref-2^{k-1}, v_ref+2^{k-1}] whose k LSBs are a match of the k bits received. This search interval is a special instance of the functions introduced earlier. The decompressed value becomes the v_ref which will be in turn used to decompress the next incoming compressed value. In the preferred embodiment, the decompressor acknowledges at least some of the packets which have been decompressed such as illustrated in Figs. 3 and 4. The number of packets which have to be acknowledged is totally flexible and is chosen to meet the specifications of the desired application. The more acknowledgments which are transmitted from the decompressor to the compressor, the higher the compression efficiency on the forward link as will be shown hereafter.

### Compression:

Reference is now made to the compressor operations. The compressor maintains a sliding window of values it has compressed and transmitted to the decompressor which are illustrated in Figs. 7A and 7B. In the one embodiment, the window holds the latest value for which it has received an acknowledgment from the decompressor and all the following transmitted values in the order they were transmitted to the decompressor. The compressor also maintains the minimum and maximum values v_min and the v_max respectively of the sliding window.

When a new uncompressed value v reaches the compressor, the compressor sends k LSBs of v such that v be in the interval ]v_i-2^{k-1}, v_i+2^{k-1}] for every v_i of the sliding window. This can be conveniently expressed by r<2^{k}-1 where r = max(|v - v_max|, |v - v_min|). The compressor thus chooses k to be the smallest integer which is more than log₂(r)+1. When the compressor receives an acknowledgment, it removes from its window all the values which have been sent prior the acknowledged value as discussed above with reference to Fig. 7B.

The following discussion demonstrates why VLE always provides correct decompression and is a very flexible compression mechanism.

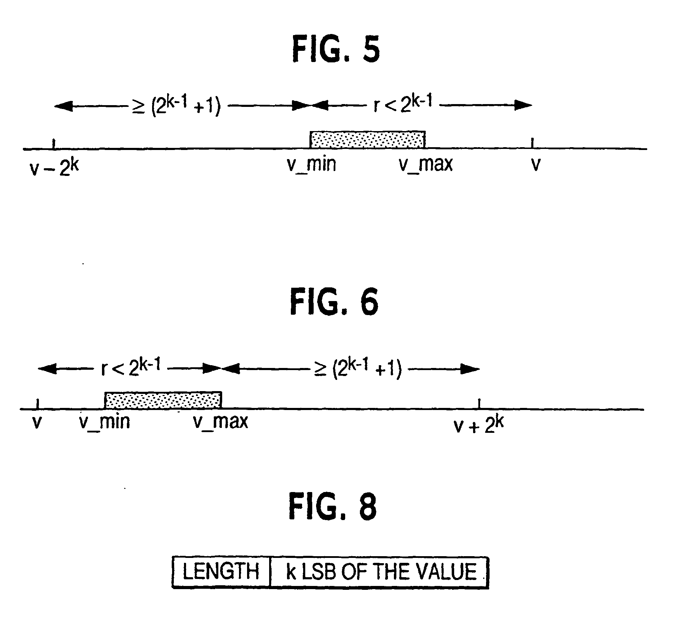

As long as the compressor and decompressor follow the above-described rules, correct decompression occurs whatever the losses are on the CD-channel between the compressor and decompressor as illustrated in Figs. 3 and 4. In effect, the reference value v_ref used by the decompressor necessarily belongs to the compressor window, as illustrated for example in Figs. 5 and 6 between points v_min and v_max, and therefore the encoded value is known to be in the interval ]v_ref-2^{k-1}, v_ref+2^{k-1}] which is the search interval used by the decompressor.

There is no error propagation with VLE. A compressed packet received by the decompressor can always be decompressed. Packet losses translate into a gradual increase in the compressed packet size.

The more frequent the acknowledgments, the less values in the window and therefore the less LSBs are likely to be sent. This holds especially in the case of header compression where the values to be compressed follow an increasing trend and where v-v_min increases for each new value v until an acknowledgment is received.

The length of the compressed value must be known to the decompressor. In some cases this length can be known without any additional signaling, for example through the framing information from lower layers of coding. If explicit signaling is needed the preferred embodiment defines a VLE format. The format may have two fields: the length field (i.e. k the number of LSB) and the compressed value field (i.e, k LSB of the original value v) as illustrated in Fig. 8.

In a preferred embodiment, the VLE length field, as illustrated in Fig. 8, is itself encoded using Huffman coding. Any other encoding methods (e.g. linear encoding) may be used. For different applications the likelihood of different lengths should be accessed and then a Huffman coding algorithm should be used to encode these data where desirable. The likelihood of encountering a given length on a communication link between the compressor and decompressor can be assessed knowing the link properties (loss and delay) and the decompressor acknowledgment period, as well as the patterns of the original values to be compressed.

To further reduce the length of the length field itself, the compressor may be constrained to choose the length of the field from a reduced set of values. For instance, assuming the uncompressed field is 32 bits and it is desired to encode with a maximum 2-bit length the following lengths which are in a decreasing order of likelihood 4 bits, 8 bits and 32 bits, appropriate code words could be the single bit 0 for 4 bits, the 2-bit value 1 0 for 8 bits and the 2-bit value 1 1 for 32 bits.

Using appropriate coding minimizes the average size of the compressed values.

Furthermore, the length information may not require dedicated bits if the length can be derived from other packet fields. For example, in a typical header compression application a packet type field is transmitted in the compressed header. This packet type field can be used to imply a default length which is rarely exceeded. In the case, where the default length is exceeded, a separate packet type is used. Since this happens only rarely the overhead is overall decreased.

If there is no feedback channel, other (out-of-band) information or additional assumptions are required to move the compressor window forward and keep the k from increasing forever. One way is to assume that at most L consecutive compressed values can be lost along the channel from the compressor to the decompressor. In other words, the compressor knows for sure that at least one out of (L + 1) consecutive compressed values arrives at the decompressor. Therefore, the compressor only needs to store in the window the last (L + 1) values that have been sent to the decompressor. Therefore, the range (v_max - v_min), and thus the value of k, depends only on the last (L + 1) values sent.

VLE can be applied to RTP header compression. Conversely to RFC 2508, there is no need to use a compressor- decompressor sequence number. Instead, the RTP sequence number is encoded using VLE. The decompressor acknowledges packets such as illustrated in Figs. 3 and 4 as described in the VLE application by sending to the compressor the RTP SN it has received.

As discussed below regarding optimal acknowledgments, the decompressor does not have to return the uncompressed RTP SN value.

The following example illustrates the working of the present invention for RTP SN compression as set forth in RFC 2508. A series of incoming packets are provided to the compressor whose SN (sequence number) are: 32, 33, 35, 36, 39, 40, 38, 41. Assuming that the decompressor has acknowledged the packet whose sequence number is 35, the compressor keeps a window of sequence numbers as discussed above transmitted since the last acknowledged packet. When the acknowledgment is received, the compressor window is thus: 35, 36, 39, 40, 38, 41. Now it is assumed that a new SN value is coming to the compressor having a SN value of 43. The compressor looks for its window maximum and finds 41. The compressor looks for is window minimum and finds 35. The compressor computes the distance r of the incoming value to its upper (43-41 = 2) and lower (43-35 = 8) bounds. The maximum distance is 8. The compressor has to transmit a number of bits k such that the integer is more than log₂^{r}+1 with 2^{k} being greater than 17 in this example. This number is k=5. Since 43 is written in binary format as 101011, the compressor sends the 5 LSB, i.e. 01011. The decompressor reference value is the last value decompressed by the decompressor and it is for sure one of the values in the compressor window. The decompressor decompresses the incoming value (01011) by returning the value whose 5 LSBs are 01011 and which is the closest to the reference value. Whatever the reference value, this value will always be 43. For example, if it is assumed that the last value received by the decompressor is 40 when it receives the compressed value (i.e. 38 and 41 were lost on the link between the compressor and the decompressor), the search interval used by the decompressor is [25, 56] or in binary format [011001, 111000]. The only value in the interval whose last LSBs are 01011 is 101011, i.e. 43.

Another way for the decompressor to pick the value of k is to choose the closest value to 40 whose LSBs are 01011. The number 40 is 101000 in binary format. The closest value to 101000 whose last LSBs are 01011 is 01011, i.e. 43. This illustrates that whatever the losses on the compressor-decompressor link, the VLE allows determination of the minimum or reduced number of LSB bits to be sent which will provide correct decompression.

Figs. 5 and 6 illustrate the picking of k such that the current value to be VLE encoded is among the values having the same LSB and is closest to either a maximum or a minimum in the window. Fig. 5 illustrates the case where v is greater than v_max and Fig. 6 illustrates the case where V is less than v_min.

In the packets where the RTP time stamp or the IP-ID field is sent, these fields are encoded using the same window of transmitted packets as used for SN encoding. Therefore, the decompressor does not send back these fields on the reverse/feedback channel in order to acknowledge them. The window can also be seen as a window of vectors (SN, TS, IP-ID). A given vector can be acknowledged by returning only the SN field.

One embodiment performs header compression based on an acknowledgment framework to transmit SN, TS and IP-ID when these fields have to be transmitted. Other encodings can be used for TS and IP-ID. This header compression scheme is summarized below. Transition to FO and SO States Using Acknowledgments

When a new session starts, the compressor operates in FH state until receiving an acknowledgment (ACK) from the decompressor, indicating that at least one FH packet has been received. It is the responsibility of the decompressor to acknowledge an FH packet as soon as it receives it, so that the compressor can transit from FH state to FO state. Acknowledgments may contain either the compressed current value which is decompressed by the decompressor or the uncompressed current value. Either quantity permits the compressor to update the state of compression and initiate discarding of the old values.

In the FO state, the compressor transmits FO packets and the decompressor is supposed to acknowledge received FO packets (not necessarily every FO packet). If the compressor determines (based on the ACKs) that the decompressor has established an FOD, and that FOD is same as the FOD between the current header being transmitted and the last transmitted header, the compressor then advances to SO state and starts sending SO packets.

Due to the reasons discussed above, the compressor may have to fallback from SO state to FO state. However, the compressor never transits back to FH state unless some exceptional events happen, such as decompressor loses its contexts because of system crash. Whenever the compressor is in FO state, it tries to advance to SO state as described above.

Suitable packet types are disclosed in Application Serial No. 09/536,639, filed on March 28,2000, entitled "Method and System for Transmitting and Receiving Packets".

Two variations of VLE, referred to Fixed Length Encoding (FLE) and One Sided Variable Length Encoding (OVLE) are described below. Fixed Length Encoding (FLE)

Fixed length encoding may be used, if it is known for sure that, the range r = (v_max - v_min) never exceeds an upper-bound. Every value is encoded with the same number of bits which is the smallest number of bits needed to cover this range. The length does not need to be transmitted in that case since it is assumed to be a known constant.

### One Sided Variable Length Encoding (OVLE)

The previously described VLE is based on a function which maps to a reference value v_ref and a number of bits k which returns the search interval ]v_ref-2^{k-1}, v_ref+2^{k-1}]. This is very general and flexible, as it can accommodate arbitrary changes (positive, negative) from one value to the next. However, this interval is not the most efficient when used for a field which is monotonic. In effect, the decompressor picks up a decompressed value only in the subset ]v_ref, v_ref+2^{k-1}].

In the case of RTP header compression, the fields usually arrive to the compressor in increasing order. However, there are exceptions because of possible misordering upstream from the compressor or in the case of the timestamp, an encoder might not deliver the coded frames in the order they were sampled. In order to improve efficiency, it may be worth using a function which would return a search interval which is not centered on v_ref, for instance the interval ]v_ref-2^{k-2}, v_ref+3*2^{k-2}].

When VLE is used as part of an adaptive header compression application, it is possible to use the interval ]v_ref, v_ref+2^{k}] which is the most efficient for a given k. This is referred to as one sided variable length encoding (OVLE). VLE is used for FO packets and OVLE for SO packets as long as the compressor incoming values are increasing. In the case that a misordering of packets occurs before the compressor, the compressor always compresses the packet as an FO packet. Alternatively, the compressor could reorder and/or drop packets in order to stay in the SO state even if misordering occurs.

### An Optimal Acknowledgment Algorithm for the Variable Length Encoding (VLE) and One-sided VLE (OVLE) of Compressed Data

To improve the overall compression efficiency, it is desirable to keep the size of the acknowledgment sent by the decompressor to the compressor to a minimum. In the algorithm discussed herein, the decompressor only needs to send in an acknowledgment the same number of bits (or at most 2 more bits, as described later) as it has received in the compressed message.

As described in VLE and OVLE, the compressor maintains a sliding window of values VSW and stores each of the original uncompressed values in VSW after transmission to the decompressor.

### VSW: V₁, V₂, v₃, ... Vᵢ, ...vₙ Note: V₁ is the oldest value, and vₙ the youngest)

### Case 1: Single Encoding Method

It is assumed that only one encoding method is used (either VLE or OVLE) and both the compressor and the decompressor know which one is being used. When the decompressor successfully receives a compressed value and decides to acknowledge it, it simply copies the received compressed value into the acknowledgment and transmits it back to the compressor.

When the compressor receives an acknowledgment message, it processes the acknowledgment in the following three steps:
1) Uses V₁ (the oldest value) in VSW as the reference value and decompresses the compressed value in the acknowledgment following the same rules as the decompressor. The decompressed value is identified as v_acked.
2) Searches the VSW from head (oldest) to tail (youngest), for the first (oldest) occurrence of v_acked.
3) Deletes all the values preceding (older than) v_acked.

It can be shown that the above algorithm works by observing the following property of the VSW:
- If vᵢ in HSW was sent by the compressor using k bits, it can be correctly decompressed using the same k bits and using any vᵢ(j≤i) as the reference value.

Specifically, v₁ can be used as the reference value to decompress any value in the VSW. Combined with the fact that an acknowledgment always acknowledges one of the values in the VSW, it is concluded that v_acked derived in step 1) is indeed the correct original value that triggered the acknowledgment message.

### Case 2: Multiple Encoding Methods

In this case, the decompressor dynamically switches encoding methods between VLE and OVLE. It is only needed to change the aforementioned algorithm slightly to handle this case. Basically, in each acknowledgment message, the decompressor must add a flag to indicate which encoding method was used to compress the received value. Therefore, when the compressor receives an acknowledgment message, it can choose the correct decompression method based on the encoding flag in the acknowledgment. As long as the property of the VSW holds, the modified algorithm is correct, based on the same reasoning as in the previous section.

Also when VLE and/or OVLE are applied to header compression, the encoding flag need not be carried explicitly in the compressed headers sent from the compressor to the decompressor, since decompressor can derive that information implicitly based on header type and other configuration information. However, on the reverse direction, the flag has to be carried explicitly in the acknowledgment message. In the worst case, 2 bits are needed to differentiate three possibilities: VLE, plus-sided OVLE, minus-side OVLE. The encoding flag could be reduced to one bit if the side information of OVLE is predefined.

### Duplicated values in VSW

There is one special case that has not been discussed above. It is possible that the same (original uncompressed) value may occur more than once in the compressor sliding window. This needs to be considered for the following two reasons: 1) in theory, the algorithm should be generic and work for any sequence of values; 2) in practice, RTP Timestamps for some video codes do have this behavior.

The problem is that, although the calculated value v_acked is still correct, the compressor cannot determine which occurrence (if it found multiple occurrences) of the v_acked in VSW actually triggered the ACK.

However, it should be noted that the algorithm works, since the compressor always chooses the first (oldest) occurrence of v_acked in VSW. If it is not the correct instance that triggered the acknowledgment, the only side effect is that less values were deleted from the VSW than should have been. As a result, the new values arriving thereafter may be encoded using more bits than necessary.

If a duplication of values seldom occurs, no modification to the aforementioned algorithm is necessary, since the compressor is brought out of its less-than-optimal state as soon as another (unambiguous) acknowledgment arrives which acknowledges a value that occurs only once in the VSW.

If duplicated values are expected to happen frequently, extra information may be added to remove the ambiguity of an acknowledgment. One example is to assign a generation number (GN) to each compressed value and require the decompressor to put the GN in the acknowledgment.

While the invention has been described with reference to its preferred embodiments, it should be understood that numerous modifications may be made thereto without departing from the scope of the appended claims.

## Claims

1. A method of compressing a current value into a reduced or a minimum number of bits for transmission from a compressor to a decompressor comprising:
maintaining a series of at least one previous value at the compressor, each previous value having different k least significant bits and which have been transmitted to the decompressor;
determining a value of k representing a smallest or reduced number of bits which allows successful decompression of the current value at the decompressor using as a reference value any value in the series of previous values, by comparing the current value with the at least one previous value to determine a maximum difference r between the current value and the at least one previous value with k being an integer chosen to be an integer which is greater than log2 (r) +1; and
transmitting the current value from the compressor to the decompressor in compressed form with the k least significant bits of the current value.

2. A method in accordance with claim 1 wherein: the value of k represents a smallest number of bits and is determined by comparing the current value with the at least one previous value to determine a maximum difference r between the current value and the at least one previous value with k being an integer chosen to be the smallest integer which is greater than log2 (r) +1.

3. A method in accordance with claim 1 or claim 2 wherein: the decompressor transmits at least one acknowledgment to the compressor which indicate that the decompressor has decompressed a value and the compressor updates the series of at least one previous value to discard at least one older previous value.

4. A method in accordance with any preceding claim further comprising: decompressing the current value at the decompressor with a reference value of a last value of the series of at least one previous value to be decompressed as a value having k least significant bits identical to the k least significant bits of the received current value which is closest to the reference value.

5. A method in accordance with claim 4 further comprising: using a search interval at the decompressor which contains values which range from less than to greater than the reference value; and choosing from the values within the search interval the value having the identical k least significant bits.

6. A method in accordance with any preceding claim wherein: the values are produced from mapping a reference value v_ref and the number of bits k to the series of at least one previous value and the current value; and the series of the at least one previous value are updated to have as an oldest value an oldest transmitted value which has been acknowledged to have been decompressed by the decompressor.

7. A method in accordance with any preceding claim wherein: the values are a function of a reference value and the number of bits k.

8. A method in accordance with claim 7 wherein: the function is [v_ref-2^{k-1}, v_ref+2^{k-1}].

9. A method in accordance with claim 7 wherein: the function is [v_ref, v_ref+2^{k}].

10. A method in accordance with claim 3 wherein: the at least one acknowledgment is the received uncompressed value.

11. A method in accordance with claim 3 wherein: the at least one acknowledgment is the received value, preferably including information used in coding a portion of the compressed value.

12. A method in accordance with claim 10 or claim 11 wherein: the at least one acknowledgment contains an oldest value in the series of previous values.

13. A method in accordance with any preceding claim wherein: the series of previous values is updated to discard older previous values based upon an estimated maximum number of values which can be lost during transmission in a sequence of values between the compressor and the decompressor.

14. A method in accordance with any preceding claim wherein: the compressed current value encodes the number k which is transmitted with the current value.

15. A method in accordance with claim 14 wherein: the encoding is Huffman encoding.

16. A method in accordance with any preceding claim wherein: the values comprise RTP headers.

17. A method in accordance with claim 13 wherein: the at least one acknowledgment is an acknowledgment of an RTP SN header representing an acknowledgment of TS and IP-ID in the RTP header.

18. A compressor for compressing a current value into a reduced or a minimum number of bits for transmission to a decompressor, the compressor comprising:
means arranged to maintain a series of at least one previous value, each previous value having different k least significant bits and which have been transmitted;
means arranged to determine a value of k representing a smallest or reduced number of bits which allows successful decompression of the current value at the decompressor using as a reference value any value in the series of previous values, by comparing the current value with the at least one previous value to determine a maximum difference r between the current value and the at least one previous value with k being an integer chosen to be an integer which is greater than log2 (r) +1; and
means for transmitting the current value to the decompressor in compressed form with the k least significant bits of the current value.

19. A compressor in accordance with claim 18 wherein: the value of k represents a smallest number of bits and the means for determining is arranged to determine the value of k by comparing the current value with the at least one previous value to determine a maximum difference r between the current value and the at least one previous value with k being an integer chosen to be the smallest integer which is greater than log2 (r) +1.

20. A compressor in accordance with claim 18 or claim 19 responsive to receiving at least one acknowledgment which indicates that the decompressor has decompressed a value to update the series of at least one previous value to discard at least one older previous value.

21. A compressor in accordance with any of claims 18 to 20 arranged to produce the values from mapping a reference value v_ref and the number of bits k to the series of at least one previous value and the current value; and to update the series of the at least one previous value to have as an oldest value an oldest transmitted value which has been acknowledged to have been decompressed by the decompressor.

22. A compressor in accordance with any of claims 18 to 21 wherein: the values are a function of a reference value and the number of bits k.

23. A compressor in accordance with claim 22 wherein: the function is [v_ref-2^{k-1}, v_ref+2^{k-1}].

24. A compressor in accordance with claim 22 wherein: the funetion is [v_ref, v_ref+2^{k}].

25. A compressor in accordance with claim 20 wherein: the at least one acknowledgment is the received uncompressed value.

26. A compressor in accordance with claim 20 wherein: the at least one acknowledgment is the received value, preferably including information used in coding a portion of the compressed value.

27. A compressor in accordance with claim 25 or claim 26 wherein: the at least one acknowledgment contains an oldest value in the series of previous values.

28. A compressor in accordance with any of claims 18 to 27 arranged to update the series of previous values to discard older previous values based upon an estimated maximum number of values which can be lost during transmission in a sequence of values to the decompressor.

29. A compressor in accordance with any of claims 18 to 28 wherein: the compressed current value encodes the number k which is transmitted with the current value.

30. A compressor in accordance with claim 29 wherein: the encoding is Huffman encoding.

31. A compressor in accordance with any of claims 18 to 30 wherein: the values comprise RTF headers.

32. A compressor in accordance with claim 28 wherein: the at least one acknowledgment is an acknowledgment of an RTP SN header represenring an acknowledgment of TS and IP-ID in the RTP header.

33. A system comprising a compressor as claimed in any of claims 18 to 32 and
a decompressor which receives the current value compressed into a minimum number of k least significant bits from the compressor.

34. A system in accordance with claim 33 when dependent on claim 20 wherein: the decompressor transmits at least one acknowledgment to the compressor which indicate that the decompressor has decompressed a value..

35. A system in accordance with claim 33 or claim 34, wherein: the decompressor decompresses the current value with a reference value of a last value of the series of the at least one previous value to be decompressed as a value having k least significant bits identical to the k least significant bits of the received current value which is closest to the reference value.

36. A system in accordance with claim 35 wherein: the decompressor uses a search interval which contains values which range from less than to greater than the reference value; and chooses from the values within the search interval the value having the identical k least significant bits.

37. A system in accordance with claim 34 or any of claims 35 and 36 when dependent on claim 34 wherein: the acknowledgments are the received uncompressed value.

38. A system in accordance with claim 34 or any of claims 35 and 36 when dependent on claim 34 wherein: the at least one acknowledgment is the received compressed value, preferably including information used in coding a portion of the compressed value.

39. A system in accordance with claims 34 or any of claims 35 to 38 when dependent on claim 34 wherein: the at least one acknowledgment is an acknowledgment of an RTP SN header representing an acknowledgment of TS and IP-ID in the RTP header.

## Revendications

1. Procédé de compression d'une valeur actuelle en un nombre réduit ou minimal d'éléments binaires pour transmission d'un compresseur à un décompresseur, comprenant les étapes consistant à :
maintenir au compresseur une série d'au moins une des valeurs antérieures, chaque valeur antérieure ayant k éléments binaires les moins significatifs différents et qui ont été transmis au décompresseur ;
déterminer une valeur de k représentant un nombre le plus petit ou réduit d'éléments binaires qui permet la décompression réussie de la valeur actuelle au décompresseur en utilisant comme valeur de référence une valeur quelconque dans la série des valeurs antérieures, en comparant la valeur actuelle avec l'au moins une valeur antérieure afin de déterminer une différence maximale r entre la valeur actuelle et l'au moins une valeur antérieure, avec k étant un nombre entier choisi de manière à être supérieur à log2 (r) + 1 ; et
transmettre la valeur actuelle du compresseur au décompresseur sous forme comprimée avec les k éléments binaires les moins significatifs de la valeur actuelle.

2. Procédé selon la revendication 1, dans lequel : la valeur de k représente un plus petit nombre d'éléments binaires et est déterminée en comparant la valeur actuelle avec l'au moins une valeur antérieure afin de déterminer une différence maximale r entre la valeur actuelle et l'au moins une valeur antérieure, avec k étant un nombre entier choisi de manière à être le plus petit nombre entier qui est supérieur à log2 (r) + 1.

3. Procédé selon la revendication 1 ou la revendication 2, dans lequel : le décompresseur transmet au compresseur au moins un accusé de réception qui indique que le décompresseur a décomprimé une valeur et le compresseur actualise la série des au moins une valeur antérieure afin d'écarter les au moins une valeur antérieure plus anciennes.

4. Procédé selon l'une quelconque des revendications précédentes comprenant en outre : l'étape consistant à décomprimer la valeur actuelle au décompresseur à l'aide d'une valeur de référence d'une dernière valeur de la série des au moins une valeur antérieure à décomprimer en tant que valeur ayant k éléments binaires les moins significatifs identiques aux k éléments binaires les moins significatifs de la valeur actuelle reçue qui est la plus proche de la valeur de référence.

5. Procédé selon la revendication 4, comprenant en outre : les étapes consistant à utiliser au décompresseur un intervalle de recherche qui contient des valeurs qui vont de moins à plus que la valeur de référence ; et à choisir parmi les valeurs dans l'intervalle de recherche la valeur ayant les k éléments binaires les moins significatifs identiques.

6. Procédé selon l'une quelconque des revendications précédentes, dans lequel : les valeurs sont générées à partir d'un mappage d'une valeur de référence v_ref et du nombre k d'éléments binaires à la série des au moins une valeur antérieure et à la valeur actuelle ; et la série des au moins une valeur antérieure et à la valeur actuelle est actualisée de manière à avoir comme valeur la plus ancienne une valeur la plus ancienne transmise dont il a été accusé réception comme ayant été décomprimée par le décompresseur.

7. Procédé selon l'une quelconque des revendications précédentes, dans lequel : les valeurs sont une fonction d'une valeur de référence et du nombre k d'éléments binaires.

8. Procédé selon la revendication 7, dans lequel : la fonction est [v_ref - 2^{k-1}, v_ref + 2^{k-1}].

9. Procédé selon la revendication 7, dans lequel : la fonction eat [v_ref, v_ref + 2^{k}].

10. Procédé selon la revendication 3, dans lequel : l'au moins un accusé de réception est la valeur non comprimée reçue.

11. Procédé selon la revendication 3, dans lequel : l'au moins un accusé de réception est la valeur reçue, comprenant de préférence l'information utilisée dans le codage d'une partie de la valeur comprimée.

12. Procédé selon la revendication 10 ou la revendication 11, dans lequel : l'au moins un accusé de réception contient une valeur la plus ancienne dans la série des valeurs antérieures.

13. Procédé selon l'une quelconque des revendications précédentes, dans lequel : la série des valeurs est actualisée de manière à écarter les valeurs antérieures plus anciennes en se basant sur un nombre maximal estimé de valeurs qui peuvent être perdues au cours de la transmission dans une séquence de valeurs entre le compresseur et le décompresseur.

14. Procédé selon l'une quelconque des revendications précédentes, dans lequel : la valeur actuelle comprimée code le nombre k qui est transmis avec la valeur actuelle.

15. Procédé selon la revendication 14, dans lequel : le codage est un codage de Huffman.

16. Procédé selon l'une quelconque des revendications précédentes, dans lequel : les valeurs comprennent des en-têtes RTP.

17. Procédé selon la revendication 13, dans lequel : l'au moins un accusé de réception est un accusé de réception d'un en-tête RTP SN représentant un accusé de réception de TS et IP-ID dans l'en-tête RTP.

18. Compresseur destiné à comprimer une valeur actuelle en un nombre réduit ou minimal d'éléments binaires pour transmission à un décompresseur, le compresseur comprenant :
un moyen disposé de manière à maintenir une série d'au moins une des valeurs antérieures, chaque valeur antérieure ayant k éléments binaires les moins significatifs différents et qui ont été transmis ;
un moyen disposé de manière à déterminer une valeur de k représentant un nombre le plus petit ou réduit d'éléments binaires qui permet la décompression réussie de la valeur actuelle au décompresseur en utilisant comme valeur de référence une valeur quelconque dans la série des valeurs antérieures, en comparant la valeur actuelle avec l'au moins une valeur antérieure afin de déterminer une différence maximale r entre la valeur actuelle et l'au moins une valeur antérieure, avec k choisi de manière à être un nombre entier qui est supérieur à log2 (r) + 1 ; et
un moyen disposé de manière à transmettre la valeur actuelle au décompresseur sous forme comprimée avec les k éléments binaires les moins significatifs de la valeur actuelle.

19. Compresseur selon la revendication 18, dans lequel : la valeur de k représente un plus petit nombre d'éléments binaires et le moyen de détermination est disposé de manière à déterminer la valeur de k en comparant la valeur actuelle avec l'au moins une valeur antérieure afin de déterminer une différence maximale r entre la valeur actuelle et l'au moins une valeur antérieure, avec k étant un nombre entier choisi pour être le plus petit nombre entier qui est supérieur à log2 (r) + 1.

20. Compresseur selon la revendication 18 ou la revendication 19, sensible à la réception d'au moins un accusé de réception qui indique que le décompresseur a décomprimé une valeur et le compresseur actualise la série d'au moins une valeur antérieure afin d'écarter au moins une valeur antérieure plus ancienne.

21. Compresseur selon l'une quelconque des revendications 18 à 20, disposé de manière à générer les valeurs à partir d'un mappage d'une valeur de référence v_ref et du nombre k d'éléments binaires à la série des au moins une valeur antérieure et à la valeur actuelle ; et à actualiser la série des au moins une valeur antérieure et la valeur actuelle de manière à avoir comme valeur la plus ancienne une valeur la plus ancienne transmise dont il a été accusé réception comme ayant été décomprimée par le décompresseur.

22. Compresseur selon l'une quelconque des revendications 18 à 21, dans lequel : les valeurs sont une fonction d'une valeur de référence et du nombre k d'éléments binaires.

23. Compresseur selon la revendication 22, dans lequel : la fonction est [v_ref - 2^{k-1}, v_ref + 2^{k-1}].

24. Compresseur selon la revendication 22, dans lequel : la fonction est [v_ref, v_ref + 2^{k}].

25. Compresseur selon la revendication 20, dans lequel : l'au moins un accusé de réception est la valeur non comprimée reçue.

26. Compresseur selon la revendication 20, dans lequel : l'au moins un accusé de réception est la valeur reçue, comprenant de préférence l'information utilisée dans le codage d'une partie de la valeur comprimée.

27. Compresseur selon la revendication 25 ou la revendication 26, dans lequel : l'au moins un accusé de réception contient une valeur la plus ancienne dans la série des valeurs antérieures.

28. Compresseur selon l'une quelconque des revendications 18 à 27 disposé de manière à actualiser la série des valeurs antérieures de manière à écarter les valeurs antérieures plus anciennes en se basant sur un nombre maximal estimé de valeurs qui peuvent être perdues au cours de la transmission au décompresseur dans une séquence de valeurs.

29. Compresseur selon l'une quelconque des revendications 18 à 28, dans lequel : la valeur actuelle comprimée code le nombre k qui est transmis avec la valeur actuelle.

30. Compresseur selon la revendication 29, dans lequel : le codage est un codage de Huffman.

31. Compresseur selon l'une quelconque des revendications 18 à 30, dans lequel : les valeurs comprennent des en-têtes RTP.

32. Compresseur selon la revendication 28, dans lequel : l'au moins un accusé de réception est un accusé de réception d'un en-tête RTP SN représentant un accusé de réception de TS et IP-ID dans l'en-tête RTP.

33. Système comprenant un compresseur selon l'une quelconque des revendications 18 à 32 et
un décompresseur qui reçoit du compresseur la valeur actuelle comprimée selon un nombre minimal k d'éléments binaires les moins significatifs.

34. Système selon la revendication 33 en cas de dépendance de la revendication 20, dans lequel : le décompresseur transmet au compresseur au moins un accusé de réception qui indique que le décompresseur a décomprimé une valeur.

35. Système selon la revendication 33 ou la revendication 34, dans lequel : le décompresseur décomprime la valeur actuelle à l'aide d'une valeur de référence d'une dernière valeur de la série d'au moins une valeur antérieure à décomprimer en tant que valeur ayant k éléments binaires les moins significatifs identiques aux k éléments binaires les moins significatifs de la valeur actuelle reçue qui est la plus proche de la valeur de référence.

36. Système selon la revendication 35, dans lequel : le décompresseur utilise un intervalle de recherche qui contient des valeurs qui vont de moins à plus que la valeur de référence ; et choisit parmi les valeurs dans l'intervalle de recherche la valeur ayant les k éléments binaires les moins significatifs identiques.

37. Système selon la revendication 34 ou l'une quelconque des revendications 35 et 36 en cas de dépendance de la revendication 34, dans lequel : l'au moins un accusé de réception est la valeur non comprimée reçue.

38. Système selon la revendication 34 ou l'une quelconque des revendications 35 et 36 en cas de dépendance de la revendication 34, dans lequel : l'au moins un accusé de réception est la valeur reçue, comprenant de préférence l'information utilisée dans le codage d'une partie de la valeur comprimée.

39. Système selon la revendication 34 ou l'une quelconque des revendications 35 à 38 en cas de dépendance de la revendication 34, dans lequel : l'au moins un accusé de réception est un accusé de réception d'un en-tête RTP SN représentant un accusé de réception de TS et IP-ID dans l'en-tête RTP.

## Patentansprüche

1. Verfahren zum Komprimieren eines derzeitigen Werts in eine verringerte oder eine minimale Anzahl von Bits für eine Übertragung von einem Komprimierer zu einem Dekomprimierer, umfassend:
- Aufrechterhalten einer Reihe von mindestens einem vorhergehenden Wert bei dem Komprimierer, wobei jeder vorhergehende Wert verschiedene k geringstwertige Bits aufweist, und die an den Dekomprimierer übertragen worden sind;
- Bestimmen eines Werts k, der eine kleinste oder verringerte Anzahl von Bits darstellt, die eine erfolgreiche Dekomprimierung des derzeitigen Werts bei dem Dekomprimierer ermöglicht, wobei als ein Referenzwert irgendein Wert in der Reihe von vorhergehenden Werten verwendet wird, durch Vergleichen des derzeitigen Werts mit dem mindestens einen vorhergehenden Wert, um eine maximale Differenz r zwischen dem derzeitigen Wert und dem mindestens einen vorhergehenden Wert zu bestimmen, wobei k eine ganze Zahl ist, die so gewählt ist, dass sie eine ganze Zahl größer als log2(r)+1 ist; und
- Übertragen des derzeitigen Werts von dem Komprimierer an den Dekomprimierer in komprimierter Form, mit den k geringstwertigen Bits des derzeitigen Werts.

2. Verfahren nach Anspruch 1, wobei der Wert von k eine kleinste Anzahl von Bits darstellt und durch Vergleichen des derzeitigen Werts mit dem mindestens einen vorhergehenden Wert bestimmt wird, um eine maximale Differenz r zwischen dem derzeitigen Wert und dem mindestens einen vorhergehenden Wert zu bestimmen, wobei k eine ganze Zahl ist, welche so gewählt ist, dass sie die kleinste ganze Zahl ist, die größer als log2(r)+1 ist.

3. Verfahren nach Anspruch 1 oder 2, wobei der Dekomprimierer mindestens eine Bestätigung an den Komprimierer überträgt, die angibt, dass der Dekomprimierer einen Wert dekomprimiert hat, und der Komprimierer die Reihe von mindestens einem vorhergehenden Wert aktualisiert, um mindestens einen älteren vorhergehenden Wert zu verwerfen.

4. Verfahren nach irgendeinem der vorhergehenden Ansprüche, weiter umfassend:
- Dekomprimieren des derzeitigen Werts bei dem Dekomprimierer, mit einem Referenzwert eines letzten Werts der Reihe von mindestens einem vorhergehenden Wert, um dekomprimiert zu werden, als ein Wert mit k geringstwertigen Bits, identisch mit den k geringstwertigen Bits des empfangenen derzeitigen Werts, der dem Referenzwert am nächsten liegt.

5. Verfahren nach Anspruch 4, weiter umfassend:
- Verwenden eines Suchintervalls bei dem Dekomprimierer, welches Werte enthält, die von kleiner als bis zu größer als der Referenzwert reichen; und
- Auswählen des Werts aus den Werten innerhalb des Suchintervalls, der die identischen k geringstwertigen Bits aufweist.

6. Verfahren nach irgendeinem der vorhergehenden Ansprüche, wobei:
- die Werte aus einem Abbilden eines Referenzwertes v_ref und der Anzahl von Bits k auf die Reihe von mindestens einem vorhergehenden Wert und den derzeitigen Wert erzeugt werden; und
- die Reihe des mindestens einen vorhergehenden Werts aktualisiert wird, als einen ältesten übertragenen Wert den Wert aufzuweisen, von dem bestätigt worden ist, dass er von dem Dekomprimierer dekomprimiert worden ist.

7. Verfahren nach irgendeinem der vorhergehenden Ansprüche, wobei die Werte eine Funktion eines Referenzwertes und der Anzahl von Bits k sind.

8. Verfahren nach Anspruch 7, wobei die Funktion (v_ref-2^{k-1}, v_ref+2^{k-1}) ist.

9. Verfahren nach Anspruch 7, wobei die Funktion (v_ref, v_ref+2^{k}) ist.

10. Verfahren nach Anspruch 3, wobei die mindestens eine Bestätigung der empfangene unkomprimierte Wert ist.

11. Verfahren nach Anspruch 3, wobei die mindestens eine Bestätigung der empfangene Wert ist, bevorzugt einschließlich Informationen, die beim Kodieren eines Abschnitts des komprimierten Werts verwendet worden sind.

12. Verfahren nach Anspruch 10 oder 11, wobei die mindestens eine Bestätigung einen ältesten Wert in der Reihe von vorhergehenden Werten enthält.

13. Verfahren nach irgendeinem der vorhergehenden Ansprüche, wobei die Reihe von vorhergehenden Werten aktualisiert wird, um ältere vorhergehende Werte zu verwerfen, basierend auf einer abgeschätzten maximalen Anzahl von Werten, die während der Übertragung in einer Abfolge von Werten zwischen dem Komprimierer und dem Dekomprimierer verlorengehen können.

14. Verfahren nach irgendeinem der vorhergehenden Ansprüche, wobei der komprimierte derzeitige Wert die Zahl k kodiert, übertragen mit dem derzeitigen Wert.

15. Verfahren nach Anspruch 14, wobei die Kodierung eine Huffman Kodierung ist.

16. Verfahren nach irgendeinem der vorhergehenden Ansprüche, wobei die Werte RTP Anfangsblöcke umfassen.

17. Verfahren nach Anspruch 13, wobei die mindestens eine Bestätigung eine Bestätigung eines RTP SN Anfangsblocks ist, die eine Bestätigung der TS und IP-ID in dem RTP Anfangsblock darstellt.

18. Komprimierer zum Komprimieren eines derzeitigen Werts in eine verringerte oder eine minimale Anzahl von Bits für eine Übertragung an einen Dekomprimierer, wobei der Komprimierer umfasst:
- Mittel, die eingerichtet sind, eine Reihe von mindestens einem vorhergehenden Wert aufrechtzuerhalten, wobei jeder vorhergehende Wert verschiedene k geringstwertige Bits aufweist, und die übertragen worden sind;
- Mittel, die eingerichtet sind, einen Wert von k zu bestimmen, der eine kleinste oder verringerte Anzahl von Bits darstellt, die eine erfolgreiche Dekomprimierung des derzeitigen Werts an dem Dekomprimierer ermöglicht, wobei als ein Referenzwert irgendein Wert in der Reihe von vorhergehenden Werten verwendet wird, durch Vergleichen des derzeitigen Werts mit dem mindestens einen vorhergehenden Wert, um eine maximale Differenz r zwischen dem derzeitigen Wert und dem mindestens einen vorhergehenden Wert zu bestimmen, wobei k eine ganze Zahl ist, die so gewählt ist, dass sie eine ganze Zahl größer als log2(r)+1 ist; und
- Mittel zum Übertragen des derzeitigen Werts an den Dekomprimierer in komprimierter Form, mit den k geringstwertigen Bits des derzeitigen Werts.

19. Komprimierer nach Anspruch 18, wobei der Wert von k eine kleinste Zahl von Bits darstellt und das Mittel zum Bestimmen eingerichtet ist, den Wert von k zu durch Vergleichen des derzeitigen Werts mit dem mindestens einen vorhergehenden Wert zu bestimmen, um eine maximale Differenz r zwischen dem derzeitigen Wert und dem mindestens einen vorhergehenden Wert zu bestimmen, wobei k eine ganze Zahl ist, welche so gewählt ist, dass sie die kleinste ganze Zahl ist, die größer als log2(r)+1 ist.

20. Komprimierer nach Anspruch 18 oder Anspruch 19, der auf einen Empfang mindestens einer Bestätigung, die angibt, dass der Dekomprimierer einen Wert dekomprimiert hat, anspricht, um die Reihe von mindestens einem vorhergehenden Wert zu aktualisieren, um mindestens einen älteren vorhergehenden Wert zu verwerfen.

21. Komprimierer nach irgendeinem der Ansprüche 18 bis 20, der eingerichtet ist, um
- die Werte aus einem Abbilden eines Referenzwertes v_ref und der Anzahl von Bits k auf die Reihe von mindestens einem vorhergehenden Wert und den derzeitigen Wert zu erzeugen; und
- die Reihe des mindestens einen vorhergehenden Werts zu aktualisieren, um als einen ältesten Wert einen ältesten übertragenen Wert aufzuweisen, von dem bestätigt worden ist, dass er von dem Dekomprimierer dekomprimiert worden ist.

22. Komprimierer nach irgendeinem der Ansprüche 18 bis 21, wobei die Werte eine Funktion eines Referenzwertes und der Anzahl von Bits k sind.

23. Komprimierer nach Anspruch 22, wobei die Funktion (v_ref-2^{k-1}, v_ref+2^{k-1}) ist.

24. Komprimierer nach Anspruch 22, wobei die Funktion (v_ref, v_ref+2^{k}) ist.

25. Komprimierer nach Anspruch 20, wobei die mindestens eine Bestätigung der empfangene unkomprimierte Wert ist.

26. Komprimierer nach Anspruch 20, wobei die mindestens eine Bestätigung der empfangene Wert ist, bevorzugt einschließlich Informationen, die beim Kodieren eines Abschnitts des komprimierten Werts verwendet worden sind.

27. Komprimierer nach Anspruch 25 oder 26, wobei die mindestens eine Bestätigung einen ältesten Wert in der Reihe von vorhergehenden Werten enthält.

28. Komprimierer nach irgendeinem der Ansprüche 18 bis 27, eingerichtet, um die Reihe von vorhergehenden Werten zu aktualisieren, um ältere vorhergehende Werte zu verwerfen, basierend auf einer abgeschätzten maximalen Anzahl von Werten, die während einer Übertragung in einer Abfolge von Werten zwischen dem Komprimierer und dem Dekomprimierer verlorengehen können.

29. Komprimierer nach irgendeinem der Ansprüche 18 bis 28, wobei der komprimierte derzeitige Wert die Zahl k kodiert, übertragen mit dem derzeitigen Wert.

30. Komprimierer nach Anspruch 29, wobei die Kodierung eine Huffman Kodierung ist.

31. Komprimierer nach irgendeinem der Ansprüche 18 bis 30, wobei die Werte RTP Anfangsblöcke umfassen.

32. Komprimierer nach Anspruch 28, wobei die mindestens eine Bestätigung eine Bestätigung eines RTP SN Anfangsblocks ist, die eine Bestätigung der TS und IP-ID in dem RTP Anfangsblock darstellt.

33. System, umfassend einen Komprimierer nach irgendeinem der Ansprüche 18 bis 32 und einen Dekomprimierer, welcher den derzeitigen Wert, komprimiert in eine minimale Anzahl k geringstwertiger Bits von dem Komprimierer empfängt.

34. System nach Anspruch 33, wenn abhängig von Anspruch 20, wobei der Dekomprimierer mindestens eine Bestätigung an den Komprimierer überträgt, die angibt, dass der Dekomprimierer einen Wert dekomprimiert hat.

35. System nach Anspruch 33 oder Anspruch 34, wobei der Dekomprimierer den derzeitigen Wert mit einem Referenzwert eines letzten Werts der Reihe des mindestens einen vorhergehenden Werts dekomprimiert, um als ein Wert dekomprimiert zu werden, der k geringstwertige Bits aufweist, die identisch sind zu den k geringstwertigen Bits des empfangenen derzeitigen Werts, der dem Referenzwert am nächsten liegt.

36. System nach Anspruch 35, wobei der Dekomprimierer ein Suchintervall verwendet, welches Werte enthält, die von kleiner als bis zu größer als der Referenzwert reichen; und aus den Werten innerhalb des Suchintervalls den Wert auswählt, der die identischen k geringstwertigen Bits aufweist.

37. System nach Anspruch 34 oder irgendeinem der Ansprüche 35 und 36, wenn abhängig von Anspruch 34, wobei die Bestätigungen die empfangenen unkomprimierten Werte sind.

38. System nach Anspruch 34 oder irgendeinem der Ansprüche 35 und 36, wenn abhängig von Anspruch 34, wobei die mindestens eine Bestätigung der empfangene unkomprimierte Wert ist, bevorzugt einschließlich Informationen, die beim Kodieren eines Abschnitts des komprimierten Werts verwenden worden sind.

39. System nach Anspruch 34 oder irgendeinem der Ansprüche 35 bis 38, wenn abhängig von Anspruch 34, wobei die mindestens eine Bestätigung eine Bestätigung eines RTP SN Anfangsblocks ist, die eine Bestätigung der TS und IP-ID in dem RTP Anfangsblock darstellt.
